# EUROPÄISCHE PATENTSCHRIFT

(11) **EP 2 175 044 B1**
(45) Veröffentlichungstag und Bekanntmachung des Hinweises auf die Patenterteilung: **29.05.2019**
(21) Anmeldenummer: 09012663.2
(22) Anmeldetag: 07.10.2009
(51) Int. Cl.: C23C 14/35, H01J 37/34

(54) **PVD-Beschichtungsverfahren, Vorrichtung zur Durchführung des Verfahrens und nach dem Verfahren beschichtete Substanzen**
PVD coating method, device for carrying out the procedure and substances coated with the procedure
Procédé de revêtement PVD, dispositif d'exécution du procédé et substances revêtues selon ce procédé

(30) Priorität: 07.10.2008 DE 102008050499
(43) Veröffentlichungstag der Anmeldung: 14.04.2010
(73) Patentinhaber: Systec System- und Anlagentechnik GmbH & Co. KG, 97753 Karlstadt (DE)
(72) Erfinder: Zufraß, Thorsten, 97762 Hammelburg (DE)
(74) Vertreter: Plate, Jürgen

(56) Entgegenhaltungen:
- WO-A1-02/103078
- WO-A1-2006/114610
- WO-A1-2007/009634
- WO-A1-2007/129021
- WO-A1-2008/155051
- WO-A2-2004/044261
- DE-A1-102006 021 994
- US-B1- 6 413 382
- PAULITSCH J ET AL: "Structure and mechanical properties of CrN/TiN multilayer coatings prepared by a combined HIPIMS/UBMS deposition technique" THIN SOLID FILMS, Bd. 517, Nr. 3, 28. Juni 2008 (2008-06-28) , Seiten 1239-1244, XP25712317 Switzerland ISSN: 0040-6090 DOI: 10.1016/j.tsf.2008.06.080
- MUNZ W -D ET AL: "Industrial applications of HIPIMS" JOURNAL OF PHYSICS: CONFERENCE SERIES IOP PUBLISHING LTD. UK, Bd. 100, 1. März 2008 (2008-03-01), Seiten 1-6, XP002565193 ISSN: 1742-6596 DOI: 10.1088/1742-6596/100/8/082001
- HOVSEPIAN P EH ET AL: "Novel TiAlCN/VCN nanoscale multilayer PVD coatings deposited by the combined high-power impulse magnetron sputtering/unbalanced magnetron sputtering (HIPIMS/UBM) technology" VACUUM, PERGAMON PRESS, GB, Bd. 82, Nr. 11, 19. Juni 2008 (2008-06-19) , Seiten 1312-1317, XP022733461 ISSN: 0042-207X [gefunden am 2008-04-08]
- REINHARD ET AL: "CrN/NbN superlattice structured coatings with enhanced corrosion resistance achieved by high power impulse magnetron sputtering interface pre-treatment" THIN SOLID FILMS, ELSEVIER-SEQUOIA S.A. LAUSANNE, CH, Bd. 515, Nr. 7-8, 15. Februar 2007 (2007-02-15), Seiten 3685-3692, XP005890773 ISSN: 0040-6090

## Beschreibung

Die vorliegende Erfindung betrifft ein Verfahren zur PVD-Beschichtung von Substraten, eine Vorrichtung zur Durchführung des Verfahrens.

Für die Erzeugung von dünnen Beschichtungen auf Substraten sind viele verschiedene Techniken bekannt. Diese können im wesentlichen zwei Gruppen zugeordnet werden, die als chemische (CVD) und physikalische Dampfphasenabscheidung (PVD) bezeichnet werden. Bei der CVD-Methode werden einer Beschichtungskammer gasförmige Reaktanten zugeführt, die miteinander reagieren und auf einem Substrat als dünner Film kondensieren. Damit eine chemische Reaktion stattfindet, muß die Temperatur nahe der Oberfläche des Substrates in der Regel in einem Bereich oberhalb von 1000 °C liegen. Die hohe Temperatur fördert die Diffusion der filmbildenden Reaktanten bzw. des Reaktionsproduktes in die Oberfläche des Substrates und verbessert die Haftung der dünnen Schicht. Allerdings ist hiermit der Nachteil verbunden, dass die homologe Temperatur, d.h. der Quotient aus Wachstums- und Schmelztemperatur häufig einen Wert um 0,8 annimmt. Dadurch kommt es in erhöhtem Maße zu Rekristallisation und damit verbunden zu einer Phasenumwandlung, welche die Schicht- und Oberflächeneigenschaften in nachteiliger Weise beeinflußen kann. Deshalb werden andere Methoden, wie Plasma-unterstützte CVD (PACVD) bevozugt. PACVD ermöglicht es, die Wachstums- bzw. Abscheidetemperatur auf Werte um 700 °C abzusenken, so dass Rekristallisationsprozesse in verringertem Maße auftreten.

Bei der PVD-Methode liegt das Schichtmaterial zunächst in fester Form als sogenanntes Target vor. Das Target wird mittels verschiedener Methoden in die gasförmige Phase überführt, insbesondere durch thermisches Verdampfen oder durch Sputtern (Zerstäuben), um hieran anschließend auf dem Substrat zu kondensieren. Im Gegensatz zu CVD ist es bei PVD möglich, das Substrat auf niedriger Temperatur weit unter dem Schmelzpunkt des Schichtmaterials zu halten. Somit kann mittels PVD das Schichtmaterial auch in einer amorphen metastabilen Phase abgeschieden werden.

Für die industrielle PVD-Beschichtung von Substraten mit funktionellen oder dekorativen Schichten verschiedenster chemischer Zusammensetzung hat sich die Sputtertechnik bewährt. Beim Sputtern wird ein Füll- oder Sputtergas wie beispielsweise Argon bei niedrigem Druck im Bereich von 10⁻⁴ bis 0,1 mbar ionisiert. Die Ionisierung erfolgt durch Stöße zwischen Elektronen und Atomen des Sputtergases. Die positiv geladenen Ionen des Sputtergases werden durch ein negatives elektrisches Potential auf das Target der Sputterkathode hin beschleunigt und bombardieren dieses. Durch das Bombardement mit Ionen des Sputtergases werden Atome oder Atomcluster aus dem Targetmaterial herausgeschlagen. Ein Teil der abgesputterten Atome des Targets kondensiert auf Substraten, die in der Nähe des Targets angeordnet sind. Auf diese Weise entstehen sehr dünne Schichten des Targetmaterials auf den Substraten.

Die Eigenschaften von Sputterschichten, wie Haftung auf dem Substrat, Dichte und Mikrostruktur können durch ionisierte PVD (IPVD) in vorteilhafter Weise beeinflußt werden. Bei der IPVD-Methode werden die in die Gasphase überführten Atome des Targetmaterials ionisiert und mittels eines an das Substrat angelegten negativen Potentials, der sogenannten Biasspannung U_{B} auf das Substrat hin beschleunigt. Je nach Höhe der Biasspannung U_{B} und dem Ladungszustand der Targetionen (ein- bis mehrfach positiv), treffen die Targetionen mit mehr oder minder hoher kinetischer Energie auf das Substrat auf. Abhängig von der kinetischen Energie der Targetionen treten dabei folgende Wechselwirkungen auf:
- Implantation von Targetionen in die Oberfläche des Substrates (Ionenimplantation)
- Entfernung von Verunreinigungen von der Substratoberfläche (Ionenätzung)
- Stöße zwischen den Targetionen und den Atomen der Sputterschicht, wobei die Atome der Sputterschicht ihre Position wechseln und durchmischt werden (Ionenmischung)

Magnetronsputtern (MS) stellt eine besonders effektive Art des Sputterns dar. Beim Magnetronsputtern werden in der Nähe des Targets ein zur Targetoberfläche parallel gerichtetes Magnetfeld und ein dazu senkrecht gerichtetes elektrisches Feld erzeugt. Auf die durch das elektrische Feld beschleunigten Elektronen wirkt die magnetische Lorentzkraft, welche die Elektronen auf spiralförmige Bahnen lenkt. Dieser Vorgang wird auch als magnetischer Einschluß (magnetic confinement) bezeichnet. In dem Raumvolumen des magnetischen Einschlusses legt jedes Elektron eine lange Wegstrecke zurück, wobei es mit vielen Atomen des Sputtergases kollidiert. Hierdurch werden auch bei niedrigem Druck des Sputtergases besonders effektiv Ionen erzeugt. Zum Sputtern von leitfähigen Materialien (z.B. Wolfram-Target) oder reaktiven Komponenten (z.B. Silizium-Target und Stickstoff im Sputtergas zur Erzeugung von Si₃N₄-Schichten) wird bevorzugt Gleichstrom-Magnetronsputtern (dcMS) eingesetzt. Typische Betriebsparameter für dcMS sind nachfolgend aufgelistet:

| Betriebsparameter | Wert |
|---|---|
| Kathodenpotential | -300 bis -900 V |
| Magnetische Feldstärke | 0,1 bis 1 T |
| Gasdruck | 1 bis 10 mTorr |
| Target Stromdichte | 100 mA·cm⁻² |
| Target Leistungsdichte | 50 W·cm⁻² |

Einen Nachteil der dcMS stellt jedoch die geringe Ionisierung der Targetmaterialien im Bereich von wenigen Prozent dar. Um die Ionisierung zu erhöhen, müßte die elektrische Leistungsdichte an dem Target auf Werte gesteigert werden, bei denen die Temperatur an der Targetoberfläche trotz Einsatz effektiver Kühlmethoden den Schmelzpunkt überschreitet.

Grundsätzlich darf die zur Erzielung einer hohen Ionisierung der Targetmaterialien erforderliche Leistungsdichte am Target nur während kurzer Zeiten (transient) einwirken. Im Stand der Technik sind hierzu die Methode des Lichtbogen-Sputterns (Arc Sputtering) und des Hochleistungsimpuls-Sputterns bekannt.

Beim Lichtbogen-Sputtern wird das Targetmaterial durch eine Lichtbogenentladung mit im wesentlichen zeitlich konstanter elektrischer Leistung verdampft. Die Lichtbogenentladung ist auf einen kleinen Brennfleck beschränkt, der mit hoher Geschwindigkeit über die Targetoberfläche wandert bzw. gelenkt wird. Durch die schnelle Ablenkung des Brennflecks wird die Targetoberfläche lokal kurzzeitig aufgeschmolzen bzw. verdampft und das Targetmaterial hochgradig ionisiert. Allerdings weisen Lichtbogenentladungen den Nachteil auf, dass durch die explosionsartige Verdampfung der Targetoberfläche mikroskopische Tröpfchen des Targetmaterials, sogenannte Droplets, auf dem Substrat deponiert werden. Diese Droplets wirken sich nachteilig auf die Schichteigenschaften aus.

Beim Hochleistungsimpuls-Sputtern werden dem Sputtertarget kurze Pulse mit sehr hoher elektrischer Leistung zugeführt. High Power Impuls Magnetron Sputtering (HIPIMS) stellt eine besonders geeignete Art der Hochleistungsimpuls-Sputterns dar und gewinnt zunehmend an industrieller Bedeutung. Das HIPIMS-Verfahren zeichnet sich durch eine impulsförmige Zufuhr der elektrischen Leistung auf das als Kathode wirkende Target aus. Die der Kathode zugeführte hohe Leistungsdichte von typischerweise 1000 bis 3000 W·cm⁻² während einer Impulsdauer von 50 bis 400 µs ergibt eine Plasmakonfiguration, die abweichend von der für dcMS charakteristischen anomalen Glimmentladung, Ähnlichkeit mit einer Lichtbogenentladung aufweist. Bei dcMS beträgt die Ionisierung des gesputterten Targetmaterials nur wenige Prozent. Demgegenüber sind beim HIPIMS-Verfahren Ionen-Konzentrationen von über 50 % (im Falle von Titan als Sputtermaterial bis zu 90 %) erzielbar. Zudem tritt ähnlich wie bei der Lichtbogenentladung Mehrfachionisierung der Targetatome auf. Hierdurch ergeben sich für die Schichtbildung sehr günstige Bedingungen, die sich unter anderem in einer sehr hohen Dichte des abgeschiedenen Materials und in seiner exzellenten Haftfestigkeit widerspiegeln.

Die WO98/40532 offenbart ein Verfahren und eine Vorrichtung mit magnetisch unterstützter Kathodenzerstäubung, wobei die Kathode mit Hochleistungspulsen betrieben wird (HIPIMS). In den Sputter-Regionen werden die Elektronen durch das Magnetfeld eingefangen, das durch Magnete in der Kathode erzeugt wird und mit dem elektrischen Feld zwischen der Anode, die Teil der Wand der Beschichtungsvorrichtung ist, und der Kathode, zusammenwirkt. Von dem Target der Kathode wird das Material gesputtert.

Aus der EP 1260603 A2 ist ein PVD-Verfahren zur Beschichtung von Subtraten bekannt, bei dem das Substrat im Plasma einer gepulsten magnetfeldgestützten Kathodenzerstäubung (HIPIMS) vorbehandelt wird. Während der Vorbehandlung wird eine Magnetron-Kathode zur Magnetfeldunterstützung eingesetzt. Nach der Vorbehandlung erfolgt eine Weiterbeschichtung z.B. mittels UBM-Kathodenzerstäubung. Für die Vorbehandlung und die Beschichtung werden identische Kathoden und identische Magnetfeldanordnungen benutzt, d. h. es handelt sich nicht um ein Mehrkathodenverfahren.

Die US 2005/0109607 betrifft ein Verfahren, bei dem eine Vorbehandlung der Substratoberfläche mittels HIPIMS vorgesehen ist und die nachfolgende Beschichtung mittels HIPIMS oder UBM erfolgt. Sowohl Vorbehandlung als auch Beschichtung erfolgen mit identischer Magnetronanordnung, so dass ein Mehrkathodenverfahren nicht vorliegt.

Die WO 2004/087994 beschreibt ebenfalls ein Verfahren zur PVD-Beschichtung von Substraten, bei welchem Ionen mittels HIPIMS oder kathodischer Bogenentladung in die Substratoberfläche implantiert werden, worauf dann die eigentliche Beschichtung mittels UBM erfolgt. Auf diese Weise wird ein dekoratives Mehrschichtsystem mit Interferenzschichten als Mehrlagenschichtsystem erzeugt, wobei auch eine HIPIMS IonenImplantation angewandt wird. Jedoch ist nachfolgend ein Beschichtungsschritt mittels HIPIMS nicht vorgesehen.

Die EP 0 428 358 B1 offenbart die gleichzeitige oder aufeinanderfolgende Beschichtung der Substratoberfläche mit mehreren unterschiedlichen Kathoden mittels UBM und einer Ionenquellenvorrichtung in Gestalt einer selbsterregten Magnetronvorrichtung. Die Beschichtung erfolgt mit Unterstützung von normalen Magnetron-Kathoden. Weder sind HIPIMS Kathoden noch eine HIPIMS Beschichtung erwähnt, ebenso wenig eine Vorbehandlung der Substratoberfläche durch HIPIMS. In dieser Druckschrift ist eine große Zahl unterschiedlicher Aufbringungsmethoden für die Beschichtung offenbart, jedoch gibt es keinen Hinweis auf eine gleichzeitige oder aufeinanderfolgende Anwendung von HIPIMS und UMB als Beschichtungsmethode.

Aus der EP 0521045 B1 ist ein Verfahren zur Ionenplattierung mit einem ersten und zweiten Magnetron bekannt, von denen jedes einen inneren Pol und einen äußeren Ringpol entgegengesetzter Polarität aufweist. Die Magnetrons sind so angeordnet, dass der äußere Ringpol eines Magnetrons und der äußere Ringpol des zweiten oder weiterer Magnetrons benachbart zu dem jeweils anderen angeordnet und von entgegengesetzter Polarität sind. Eines der Magnetrons wird im unbalancierten Zustand betrieben.

Die DE 10 2006 017 382 A1 beschreibt ein Verfahren und eine Vorrichtung zum Beschichten und/oder Behandeln von Oberflächen mittels HIPIMS, wobei mindestens zwei Kathoden simultan und/oder sequenziell gepulst werden. Die Kathoden sind über eine Schaltvorrichtung mit einer gemeinsamen Energieversorgung verbunden. An jeder Kathode wird ein HIPIMS-Prozess ausgelöst, wobei jede Kathode entweder zyklisch oder nach einem vorgegebenen Muster angesteuert wird. Die Kathoden können linear oder einander gegenüberliegend angeordnet sein.

Die WO 2007/009634 A1 beschreibt ein Verfahren und eine Vorrichtung für die Herstellung von Mehrfachschichten. Die Vorrichtung umfasst mindestens eine HIPIMS- und eine UBM-Kathode, die sequentiell oder simultan betrieben werden.

Beim HIPIMS-Verfahren wird das Sputtertarget mit Hochspannungspulsen mit einer Pulshöhe von einigen hundert bis einigen tausend Volt und einem Lastfaktor von unter 1% betrieben. Der Lastfaktor bezeichnet das Verhältnis von Pulsdauer zu Pulsabstand (Pulsabstand = 1/Pulsfrequenz). Um eine Überhitzung des Targets zu vermeiden, ist es notwendig, einen Lastfaktor unter 1 % einzuhalten, wodurch die Abscheiderate und damit die Produktivität des HIPIMS-Verfahrens um ein Vielfaches geringer ist als bei dcMS. Die auf die Targetfläche bezogene maximale Leistungsdichte der beim HIPIMS-Verfahren eingesetzten Pulse beträgt mehrere kw·cm⁻². Nach dem Aufschalten der Hochspannung auf das Target verstreicht eine Zeit von 15 bis 40 µm, bis das Plasma vor dem Target zündet und der Puls seine Maximalspannung erreicht. Nach dem Zünden des Plasmas kann es, abhängig von der Bauweise der elektrischen Energieversorgung, mehrere hundert Mikrosekunden, in der Regel um 200 µs dauern, bis der Puls abklingt.

Problematisch an dem HIPIMS-Verfahren ist, dass für das Erzeugen des bogenentladungsähnlichen Plasmas eine hohe Stromdichte von typischerweise mindestens 2 A·cm⁻² notwendig ist. Dadurch wird zum einen die Energieversorgung von HIPIMS-Kathoden teuer, zum anderen sind der Dimensionierung der Kathode bzw. des Targets enge Grenzen gesteckt. Bei den derzeit eingesetzten Anlagen beträgt die maximale Targetfläche lediglich 2000 cm². Größere Targetflächen - beispielsweise zur Beschichtung von Architekturglas - wären nur unter Verwendung wesentlich größerer und entsprechend teurer Energieversorgungseinheiten zu realisieren. In Verbindung mit dem niedrigen Lastfaktor und der geringen Beschichtungsrate sind die Betriebskosten des HIPIMS-Verfahrens im Vergeich zu den etablierten PVD-Verfahren zu hoch, um seine Anwendung als großtechnisches Beschichtungsverfahren zu ermöglichen.

Wegen der voranstehend erläuterten Probleme ist die Anwendung des HIPIMS-Verfahren im Stand der Technik im wesentlichen auf die Reinigung und Ionenimplantation von Substratoberflächen beschränk. Vereinzelt wurde für anspruchsvolle Anwendungen vorgeschlagen, HIPIMS und dcMS sequentiell oder simultan zur Abscheidung von mehrlagigen nanoskaligen Beschichtungen einzusetzen. Bei diesen Verfahren wird eine Kathode ausschließlich oder sequentiell entweder im HIPIMS- oder im dcMS-Modus betrieben.

Ein weiteres Problem des HIPIMS-Verfahrens besteht darin, dass die Kathode und die elektrische Energieversorgung starkem Verschleiß unterworfen sind und eine hohe Ausfallrate aufweisen. Die Ursache hierfür ist in der nichtlinearen Charakteristik der durch die elektrischen Hochleistungsimpulse gezündeten Plasmaentladung vor dem Target zu sehen. Aufgrund von Dichteschwankungen bzw. Stoßwellen im Plasma kann ein Teil der elektrischen Leistung reflektiert werden, wobei die Kathode und/oder Teile der elektrischen Energieversorgung als Antenne fungieren und die reflektierte Leistung aufnehmen. Hierbei können aufgrund von Resonanz oder additiver Überlagerung mit spektralen Komponenten des eingekoppelten Impulses an den Anlagenteilen Belastungsspitzen mit elektrischen Leistungen im Bereich von Megawatt entstehen.

Die vorliegende Erfindung hat die Aufgabe ein PVD-Beschichtungsverfahren mit hoher Ionisierung des Targetmaterials und guter Beschichtungsrate zur Verfügung zu stellen, wobei die voranstehend genannten Nachteile des Lichtbogen- und Hochleistungsimpuls-Sputterns, insbesondere des HIPIMS-Verfahrens vermieden werden sollen. Zudem soll eine Vorrichtung zur Durchführung des erfindungsgemäßen PVD-Beschichtungsverfahren bereit gestellt werden.

Erfindungsgemäß wird die voranstehende Aufgabe durch die Merkmale des Patentanspruchs 1 gelöst. Danach ist das in Rede stehende Verfahren zur PVD-Beschichtung von Substraten, dadurch gekennzeichnet, dass ein erstes Plasma einer elektrischen Gleichstrom-, Pulsstrom- oder hochfrequenten Wechselspannungsentladung mit einem zweiten Plasma einer elektrischen Hochleistungsimpulsentladung räumlich überlagert wird. Vorzugsweise erstrecken sich die überlagerten Plasmen in Richtung des(r) Substrat(e).

Zur Durchführung des erfindungsgemäßen Verfahrens wird eine Vorrichtung mit den Merkmalen des Patentanspruchs 10 vorgeschlagen. Die Vorrichtung ist dadurch gekennzeichnet, dass sie eine Vakuumkammer, Substratträger, unbalancierten Magnetrons ausgestalteten Kathoden, mindestens einen elektrischen Gleichstrom-, Pulsstrom- oder hochfrequenten Wechselspannungs-Generator und mindestens einen elektrischen Hochleistungsimpuls-Generator umfasst, wobei eine oder mehrere Kathoden an einen elektrischen Gleichstrom-, Pulsstrom- oder hochfrequenten Wechselspannungs-Generator und an einen elektrischen Hochleistungsimpuls-Generator angeschlossen sind. In einer weiteren Ausführungsform sind zwei, vier, sechs oder acht Teilkathoden paarweise gruppiert, wobei eine erste Teilkathode eines Paares an einen elektrischen Gleichstrom-, Pulsstrom oder hochfrequenten Wechselspannungs-Generator und eine zweite Teilkathode eines Paares an einen elektrischen Hochleistungsimpuls-Generator angeschlossen ist und die erste und zweite Teilkathode eines Paares räumlich derart zueinander angeordnet sind, dass sich die von ihnen erzeugten Plasmen überlagern.

Nach der Erfindung wird das Plasma einer elektrischen Hochleistungsimpulsentladung dazu genutzt, die Ionisierung des Plasmas einer elektrischen Gleichstrom-, Pulsstrom- oder hochfrequenten Wechselspannungsentladung, wie sie gewöhnlich für Beschichtungszwecke eingesetzt werden, zu erhöhen. Dies ermöglicht es, eine hohe Beschichtungsrate bei zugleich hoher Ionisierung des Targetmaterials und damit verbunden verbesserten Schichteigenschaften zu erzielen.

Ein weiterer Vorteil des erfindungsgemäßen Verfahrens besteht darin, dass die Hochleistungsimpulsentladung durch das quasi-permanente Plasma der elektrischen Gleichstrom-, Pulsstrom- oder hochfrequenten Wechselspannungsentladung stabilisiert wird. Aufgrund der (niedrigen) quasi-permanenten Ionendichte vor dem Target und der damit verbundenen Leitfähigkeit zündet das Plasma der Hochleistungsimpulsentladung in kontrollierter und räumlich homogener Weise.

Die Erfindung wird im folgenden anhand von Figuren näher erläutert. Es zeigen schematisch:
- Fig. 1: eine Vorrichtung zum PVD-Beschichten mit zwei simultan betriebenen Teilkathoden mit überlagerten Plasmen;
- Fig. 2: eine Vorrichtung zum PVD-Beschichten mit einer Kathode, die an einen Gleichstrom-Generator und an einen Hochleistungsimpuls-Generator angeschlossen ist; und
- Fig. 3: eine Vorrichtung mit vier unbalancierten Magnetronkathoden (UBM), die jeweils an einen Gleichstrom-Generator und an einen Hochleistungsimpuls-Generator angeschlossen sind.

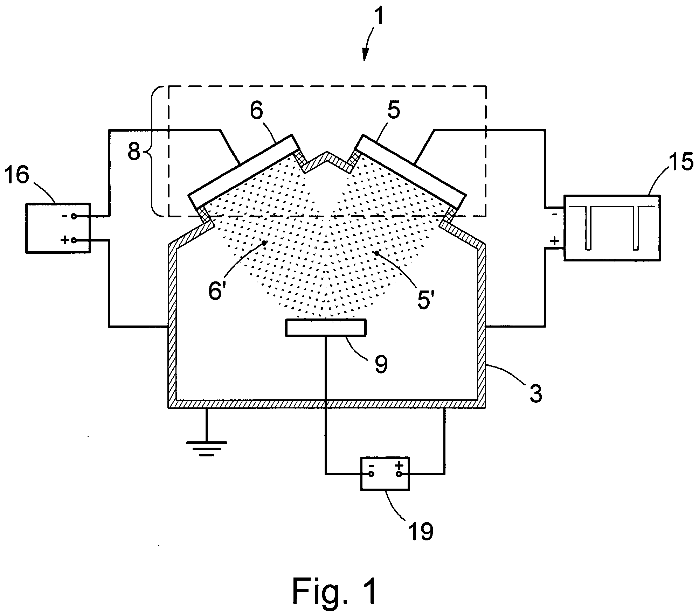

Fig. 1 zeigt schematisch ein Beispiel einer PVD-Beschichtungsvorrichtung 1 mit einer Beschichtungskammer 3 und einer Kathode 8, die mit einer Gleichstromquelle 16 und einem Hochleistungsimpuls-Generator 15 verbunden ist. Die Kathode 8 umfasst eine erste Teilkathode 6 und eine zweite Teilkathode 5, wobei die erste Teilkathode 6 an die Gleichstromquelle 16 angeschlossen ist und die zweite Teilkathode 5 mit dem Hochleistungsimpuls-Generator 15 verbunden ist. Die Teilkathoden 5 und 6 sind in einer Weise ausgerichtet, dass sich verfahrensmäßig die von ihnen erzeugten Plasmen 5' und 6' weitgehend überlagern und in Richtung eines Substrates 9 erstrecken. Das Substrat 9 ist den Teilkathoden 5 und 6 gegenüberliegend in der Beschichtungskammer 3 angeordnet. Mittels einer Spannungsversorgung 19 wird an das Substrat 9 ein negatives Biaspotential U_{B} angelegt. Die erste Teilkathode 6 wird vorzugsweise mit (konstantem) Gleichstrom betrieben.

Die erste Kathode 6 kann mit gepulstem (Gleich-)Strom bzw. mit Pulsstrom anstelle von Gleichstrom betrieben werden. Der "quasi-kontinuierliche" Pulsstrom-Modus ähnelt dem Betrieb mit Gleichstrom. Die Leistungsdichte eines Pulses auf dem Target beträgt im allgemeinen weniger als 80 W·cm⁻² und die Pulsfrequenz liegt im Bereich von größer 0 bis 350 kHz. Demgegenüber liegt die Frequenz der Hochleistungsimpulse an der zweiten Kathode 5 bei Werten von 2 bis 1000 Hz. Daher ist es angemessen, den höherfrequenten Pulsstrom-Modus im Vergleich zu den niederfrequenten Hochleistungsimpulsen als quasikontinuierlich zu bezeichnen.

In einer weiteren Verfahrensweise kann die erste Teilkathode 6 mit hochfrequenter Wechselspannung, typischerweise mit Frequenzen im Bereich von 5 bis 30 MHz betrieben werden. Diese Methode wird auch als RF-Sputtern bezeichnet, wobei die elektrische Energie vorzugsweise induktiv in das Plasma eingekoppelt wird (ICP = inductively coupled plasma).

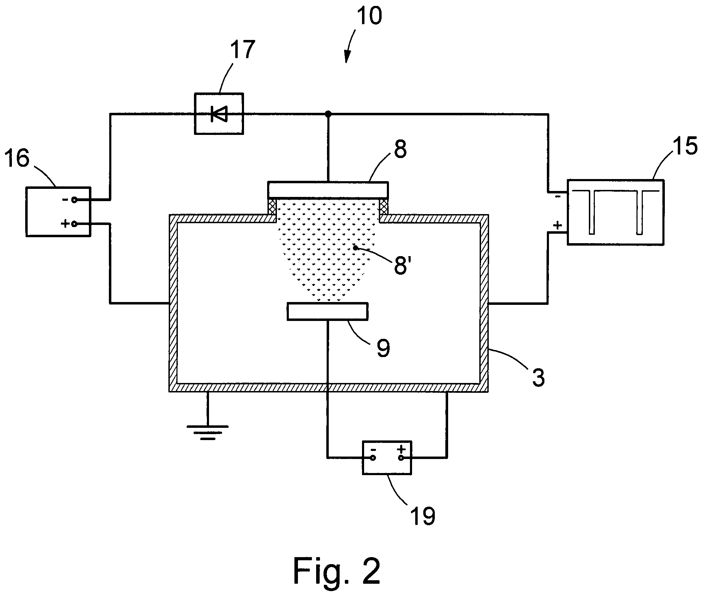

In Fig. 2 ist eine PVD-Beschichtungsvorrichtung 10 dargestellt, die eine Beschichtungskammer 3 umfasst mit einer Kathode 8 und einem der Kathode 8 gegenüberliegend angeordneten Substrat 9, das mittels einer Spannungsversorgung 19 auf einem negativen Biaspotential U_{B} gehalten wird. Die Kathode 8 ist an einen Gleichstrom-Generator 16 und an einen Hochleistungsimpuls-Generator 15 angeschlossen. Bezogen auf die Entladungsstrecke zwischen der Kathode 8 und der als Anode fungierenden Wand der Beschichtungskammer 3 sind der Gleichstrom-Generator 16 und der Hochleistungsimpuls-Generator 15 in Parallelschaltung angeordnet. Ein von der Kathode 8 erzeugtes Plasma 8' wird simultan mittels Gleichstrom- und Hochleistungsimpulsentladungen betrieben. Vorzugweise wird der Gleichstrom-Generator 16 mittels eines Entkopplungsgliedes 17 von den Pulsen des Hochleistungsimpuls-Generators 15 abgeschirmt. Das Entkopplungsglied 17 ist vorzugsweise derart ausgestaltet, dass es nach Art bekannter Hochleistungsdioden arbeitet.

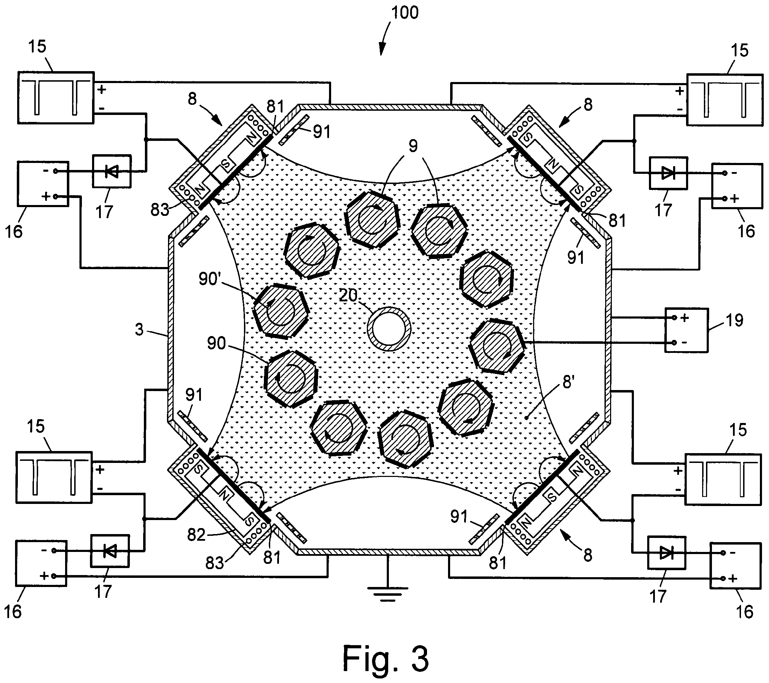

Fig. 3 zeigt eine erfindungsgemäße PVD-Beschichtungsvorrichtung 100 mit vier Kathoden 8, die jeweils an einen Gleichstrom-Generator 16 und an einen Hochleistungsimpuls-Generator 15 angeschlossen sind. Die Konfiguration jeder einzelnen der Kathoden 8, 8, ... 8 mit dem zugehörigen Gleichstromgenerator 16 und dem Hochleistungsimpuls-Generator 15 entspricht der in Figur 2 gezeigten PVD-Beschichtungsvorrichtung. Die Kathoden 8, 8, ... 8 sind als unbalancierte Magnetrons (UBM) ausgestaltet und umfassen ein (wassergekühltes) Sputtertarget 81, hinter dem ein bzw. mehrere Permanentmagnete 82 angeordnet sind, sowie elektromagnetische Spulen 83, sogenannte Helmholtzspulen. Die Permanentmagnete 82 erzeugen das für den magnetischen Einschluß vor dem Sputtertarget 81 erforderliche Magnetfeld. Um das Plasma der Kathoden 8, 8, ... 8 räumlich aufzuweiten , wird das Magnetfeld der Permanentmagnete 82 mittels der Spulen 83 im Randbereich der Kathoden 8, 8, ... 8 gemäß der bekannten UBM-Methode verstärkt. Vorzugsweise umfasst die PVD-Beschichtungsvorrichtung 100 Substratträger 90 zur Aufnahme einer Vielzahl von Substraten 9. Vorteilhafterweise sind die Substratträger 90 rotierbar, wie in Fig. 3 durch Pfeile 90' angedeutet, auf einem zentral zwischen den Kathoden 8, 8, ... 8 angeordneten Drehteller 90' angedeutet, auf einem zentral zwischen den Kathoden 8, 8, ... 8 angeordneten Drehteller (in Fig. 3 nicht gezeigt) montiert. Der Drehteller und die Substratträger 90 bestehen aus leitfähigem Material und sind galvanisch gekoppelt. Dies ermöglicht es, auf einfache Weise mittels einer Spannungsersorgung 19 ein negatives Biaspotential U_{B} an die Substrate 9 anzulegen.

Die Substrate 9 bestehen beispielsweise aus Stahl, Buntmetall, Hartmetall, Keramik, Glas oder Kunststoff und ihre Oberflächen können eine galvanische Beschichtung aufweisen.

Die Helmholtzspulen 83 sind für einen Betrieb ausgelegt, bei dem das Produkt aus Stromstärke I und Windungszahl N einen Wert von bis zu 5000 Ampere annimmt (IxN = 5000 A). Die von den Helmholtzspulen 83 erzeugten Magnetfelder haben unmittelbar vor den Sputtertragets 81 eine magnetische Feldstärke von 0 bis 4 kA·m⁻¹. Während des Beschichtungsprozesses werden die Helmholtzspulen 83 mit der gleichen magnetischen Polarität wie die äußeren Segmente der Permanentmagnete 82 betrieben. Die magnetischen Polaritäten benachbarter Helmholtzspulen 83 sind jeweils einander entgegengerichtet. Die magnetischen Feldlinien der Helmholtzspulen 83 schließen dabei das von den kathodischen Gasentladungen gebildete Plasma 8' in Richtung der Substratträger 90 bogenförmig konvex ein.

In einer nicht dargestellten Ausführungsform der PVD-Beschichtungsvorrichtung 100 sind zwei, vier, sechs oder acht Teilkathoden 5 und 6 paarweise gruppiert. Eine erste Teilkathode 6 eines Paares ist an einen elektrischen Gleichstrom-, Pulsstrom- oder hochfrequenten Wechselspannungs-Generator 16 und eine zweite Teilkathode 5 des Paares an einen elektrischen Hochleistungsimpuls-Generator 15 angeschlossen. Die erste und zweite Teilkathode 5, 6 eines Paares sind räumlich derart zueinander angeordnet, dass sich die von ihnen erzeugten Plasmen überlagern.

Die elektrische Leistungsdichte der Kathoden 8, 8, ... 8 der Vorrichtung 100 bzw. der Teilkathoden 5 der Vorrichtung 1 bzw. 100 während den HIPIMS-Entladungen liegt im Bereich von 1000 bis 10000 W.cm⁻². Bevorzugt beträgt die Leistungsdichte 2000 bis 8000 W·cm⁻² und insbesondere 2000 bis 4000 W·cm⁻². Die HIPIMS-Entladungen haben eine Pulsdauer von 50 bis 400 µs, bevorzugt 50 bis 300 µs und insbesondere 50 bis 250 µs. Während der UBM-Entladungen liegt an den Kathoden 8, 8 ... 8 der Vorrichtung 100 bzw. an den Teilkathoden 6 der Vorrichtung 1 bzw. 100 eine Leistungsdichte von 5 bis 40 W·cm⁻² und eine Entladungsspannung von -300 bis -1000 V an. Im Pulsbetrieb werden die Kathoden 8, 8 ... 8 bzw. die Teilkathoden 6 mit einer Frequenz von 0 bis 350 kHz betrieben. Die Kathoden 8, 8 ... 8 bzw. die Teilkathoden 6 können auch mit einer hochfrequenten Wechselspannung mit Frequenzen von 5 bis 30 MHz betrieben werden.

Die Biasspannung U_{B} des oder der Substrate(s) 9 liegt im Bereich von 0 bis -30000 V, vorzugsweise von 0 bis zu -2000 V und insbesondere von 0 bis zu -1000 V.

Die PVD-Beschichtungsvorrichtung 100 ist mit einer zentral angeordneten Anode 20 ausgestattet, an die ein positives Potential von einigen hundert Volt angelegt wird. Mit Hilfe der Anode 20 wird der Verluststrom, der in konventionellen PVD-Vorrichtungen zur Kammerwand 3 abfließt, in den zentralen Bereich der PVD-Beschichtungsvorrichtung 100 geleitet, wo er die Plasmadichte erhöht. Hierdurch werden die zwischen den als unbalancierten Magnetrons ausgestalteten Kathoden 8 und der Anode 20 befindlichen Substrate 9 allseitig von einem nahezu homogenen Plasma 8' eingehüllt. Die im Plasma 8' erzeugten positiven Ionen des Prozessgases werden bei Anlegen einer negativen Biasspannung an die Substrate 9 auf diese hin beschleunigt. Dieser als Ionen-Bombardement bezeichnete Vorgang verbessert die Dichte und Homogenität der auf den Substraten kondensierten Schichten.

Vor den Kathoden 8, 8, ... 8 sind Blendenvorrichtungen 91 angeordnet, die einzeln und unabhängig voneinander verfahrbar sind. Die Blendenvorrichtungen 91 ermöglichen es, eine, mehrere oder jede der Kathoden 8, 8, ... 8 teilweise abzudecken und Segmente der Kathoden, vor allem die Randbereiche, magnetisch voneinander abzuschirmen, um die bogenförmige, konvexe Ausbildung des Plasmas 8' sicher zu stellen.

Der Hochleistungsimpuls-Generator 15 umfasst eine Ladeeinheit, einen elektrischen Energiespeicher und eine Schalteinrichtung, die nachstehend kurz erläutert werden.

Die Ladeeinheit kann als Gleichstromquelle ausgebildet sein, insbesondere als Drehstrombrückengleichrichter mit nachgeschalteten Glättungselementen, und aus einem Drehstromnetz gespeist werden. Vorzugsweise umfasst die Ladeeinheit eine der Gleichstromquelle nachgeschaltete Ladeschaltung, mit der ein definierter Ausgangsstrom erzeugt wird. Die Ladeschaltung ist beispielsweise als Schaltnetzteil ausgebildet.

Mittels der Ladeeinheit wird ein elektrischer Energiespeicher in Form eines Kondensators oder einer Spule aufgeladen. Dazu wird der Energiespeicher vorzugsweise mit einem konstanten Ladestrom bis zu einem vorgegeben Energiegehalt aufgeladen. Nachdem der Energiegehalt den vorgegebenen Wert erreicht hat, wird der Ladestrom abgeschaltet und nach einer kurzen Wartezeit die im Energiespeicher enthaltene Energie auf die Kathode(n) entladen.

Die Schalteinrichtung dient zur Entladung bzw. Ableitung der in dem Energiespeicher akkumulierten Energie an die Kathoden und umfasst vorzugsweise mehrere Schalter, wobei einer Kathode oder einer Gruppe von Kathoden ein Schalter zugeordnet ist. Die Schalter können als elektromechanische Hochstromschalter ausgebildet sein. Hinsichtlich der Schaltgeschwindigkeit und des Wartungsaufwands sind jedoch elektronische Schalter bevorzugt. Elektronische Schalter sind insbesondere aus konventionellen Thyristoren, IGBTs (Insulated Gate Bipolar Transistor) oder anderen für hohe Ströme geeigneten Halbleiterschaltern aufgebaut. Vorteilhafterweise wird den Schaltern jeweils eine Freilaufdiode zum Schutz des Schalters vor induktiven Strömen antiparallel geschaltet.

Zum Einleiten des Entladevorgangs werden ein oder mehrere der Schalter der Schalteinrichtung geschlossen. Dadurch entstehen kurzzeitig sehr hohe Ströme und Stromdichten auf dem Target der Kathode, durch welche ein Hochleistungsimpuls-Plasma gezündet wird.

Verfahrensmäßig wird auf den Substraten 9 eine PVD-Beschichtung erzeugt, die eine oder mehrere mittels UBM und HIPIMS abgeschiedene Schichten umfasst. Durch HIPIMS wird zunächst eine Implantationsschicht auf den Substraten aufgebaut. Auf diese Implantationsschicht werden anschließend eine oder mehrere mittels gemeinsamer Plasmen von UBM und HIPIMS erzeugten Schichten abgeschieden. Dabei kann jede dieser Schichten aus einem oder mehreren Material(ien) aus der Gruppe umfassend Metalle, Metallnitride, Metalloxynitride, Metallkarbide, Karbonnitride und Kohlenstoff, bestehen.

### Bezugszeichenliste

- 1, 10, 100: PVD-Beschichtungsvorrichtung
- 3: Beschichtungskammer
- 5: zweite Teilkathode (für Hochleistungsimpuls-Sputtern)
- 6: erste Teilkathode (für Gleichstrom-Sputtern)
- 5': Plasma der zweiten Teilkathode 5
- 6': Plasma der ersten Teilkathode 6
- 8: Kathode für simultanes Gleichstrom- und Hochleistungsimpuls-Sputtern
- 8': Plasma der Kathode 8
- 9: Substrat
- 15: elektrischer Hochleistungsimpuls-Generator
- 16: elektrischer Gleichstrom-, Pulsstrom-, Wechselspannung-Generator
- 17: elektrisches Entkopplungsglied
- 19: Spannungsversorgung zum Anlegen eines Biaspotentials U_{B} an das Substrat
- 20: zentrale Anode
- 81: Target der Kathode 8
- 82: Permanentmagnet der Kathode 8
- 83: Elektromagnet zum Erzeugen eines magnetischen Unbalananzierfeldes
- 90: Substratträger
- 90': Rotationspfeile der Substratträger 90
- 91: Blendenvorrichtung

## Patentansprüche

1. Verfahren zur PVD-Beschichtung von Substraten, bei dem ein erstes Plasma einer elektrischen Gleichstrom-, Pulsstrom- oder hochfrequenten Wechselspannungsentladung mit einem zweiten Plasma einer Hochleistungsimpulsentladung räumlich überlagert wird und die Plasmen sich in Richtung der Substrate erstrecken, wobei das erste und zweite Plasma jeweils mittels, als unbalancierte Magnetrons ausgestalteten Kathoden (8, 8, ... 8) erzeugt wird, **dadurch gekennzeichnet, dass** die Substrate zwischen den Kathoden (8, 8, ... 8) und einer zentral angeordneten Anode (20), an er ein Potential von einigen hundert Volt anliegt, positioniert und allseitig von einem homogenen Plasma eingehüllt sind.

2. Verfahren nach Anspruch 1, **dadurch gekennzeichnet, dass** ein erstes Plasma einer unbalancierten Magnetron-Entladung (UBM) mit einem zweiten Plasma einer Hochleistungsimpulsentladung räumlich überlagert wird.

3. Verfahren nach Anspruch 1, **dadurch gekennzeichnet, dass** ein erstes Plasma einer unbalancierten Magnetron-Entladung (UBM) mit einem zweiten Plasma einer Hochleistungsimpuls-Magnetron-Entladung (HIPIMS) räumlich überlagert wird.

4. Verfahren nach Anspruch 3, **dadurch gekennzeichnet, dass** die elektrische Kathoden-Leistungsdichte der HIPIMS-Entladungen 1000 bis 10000 W·cm⁻² , bevorzugt 2000 bis 8000 W·cm⁻² und insbesondere 2000 bis 4000 W·cm⁻² beträgt.

5. Verfahren nach Anspruch 4, **dadurch gekennzeichnet, dass** die Pulsdauer der HIPIMS-Entladungen 50 bis 400 µs, bevorzugt 50 bis 300 µs und insbesondere 50 bis 250 µs beträgt.

6. Verfahren nach Anspruch 3, **dadurch gekennzeichnet, dass** an den Kathoden (8, 8, ... 8) während der UBM-Entladungen eine Leistungsdichte von 5 bis 40 W·cm⁻² und eine Entladungsspannung von -300 bis -1000 Volt anliegt.

7. Verfahren nach Anspruch 3, **dadurch gekennzeichnet, dass** die Kathoden (8, 8, ... 8) im UBM-Betrieb gepulst mit einer Frequenz von 0 bis 350 kHz betrieben werden.

8. Verfahren nach Anspruch 1, **dadurch gekennzeichnet, dass** an dem/n Substrat(en) ein negatives Potential U_{B} von 0 bis -30000 V, vorzugsweise von 0 bis zu -2000 V, und insbesondere von 0 bis zu -1000 V anliegt.

9. Verfahren nach Anspruch 3, **dadurch gekennzeichnet, dass** an jeder Kathode (8, 8, ... 8) mittels Helmholtzspulen (83) ein Unbalance-Magnetfeld generiert wird, dass das Produkt aus Stromstärke I und Windungszahl N der Helmholtzspulen einen Wert von bis zu 5000 Ampere annimmt (N×I = 5000 A), dass das Unbalance-Magnetfeld benachbarter Kathoden (8, 8) jeweils umgekehrte Polarität aufweist und dass die Unbalance-Magnetfelder aller Kathoden (8, 8, ... 8) die Entladungsplasmen (8') magnetisch einschließen.

10. Vorrichtung zur PVD-Beschichtung von Substraten nach einem Verfahren gemäß einem der Ansprüche 1 bis 9, umfassend eine Vakuumkammer (3), Substratträger (90), als unbalancierte Magnetrons ausgestaltete Kathoden (8, 8, ... 8), mindestens einen elektrischen Gleichstrom-, Pulsstrom- oder hochfrequenten Wechselspannungs-Generator (16) und mindestens einen elektrischen Hochleistungsimpuls-Generator (15), wobei die Kathoden (8, 8,... 8) in Parallelschaltung an einen elektrischen Gleichstrom-, Pulsstrom- oder hochfrequenten Wechselspannungs-Generator (16) und an einen elektrischen Hochleistungsimpuls-Generator (15) angeschlossen sind, **dadurch gekennzeichnet, dass** die Vorrichtung eine zentral angeordnete Anode (20) aufweist und die Substrate (9) zwischen der Anode (20) und den Kathoden (8, 8, ... 8) positioniert sind.

11. Vorrichtung nach Anspruch 10, **dadurch gekennzeichnet, dass** jede Kathode (8, 8, ... 8) eine Helmholtzspule (83) aufweist und dass die Helmholtzspulen (83) für einen Betrieb ausgelegt sind, bei dem das Produkt aus Stromstärke I und Windungszahl N einen Wert von bis zu 5000 Ampere annimmt (N×I = 5000 A).

12. Vorrichtung nach Anspruch 10, **dadurch gekennzeichnet, dass** sie mit einer oder mehreren unabhängig voneinander verfahrbaren Blendenvorrichtungen (91) ausgestattet ist, derart dass die Kathodentargets (81) einer oder mehrerer der Kathoden (8, 8, ... 8) separat abdeckbar sind.

## Claims

1. Process for the PVD coating of substrates, in which a first plasma of an electrical direct-current, pulsed-current or high-frequency alternating-voltage discharge is spatially superimposed with a second plasma of a high-power impulse discharge and the plasmas extend in the direction of the substrates, the first and second plasmas being respectively generated by means of cathodes (8, 8,... 8) designed as unbalanced magnetrons, **characterized in that** the substrates are positioned between the cathodes (8, 8,... 8) and a centrally arranged anode (20), to which a potential of several hundred volts is applied, and are enclosed on all sides by a homogeneous plasma.

2. Process according to Claim 1, **characterized in that** a first plasma of an unbalanced magnetron discharge (UBM) is spatially superimposed with a second plasma of a high-power impulse discharge.

3. Process according to Claim 1, **characterized in that** a first plasma of an unbalanced magnetron discharge (UBM) is spatially superimposed with a second plasma of a high-power impulse magnetron sputtering discharge (HIPIMS).

4. Process according to Claim 3, **characterized in that** the electrical cathode power density of the HIPIMS discharges is 1000 to 10 000 W.cm⁻², preferably 2000 to 8000 W·cm⁻² and in particular 2000 to 4000 W·cm⁻².

5. Process according to Claim 4, **characterized in that** the pulse duration of the HIPIMS discharges is 50 to 400 *µ*s, preferably 50 to 300 *µ*s and in particular 50 to 250 *µ*s.

6. Process according to Claim 3, **characterized in that** at the cathodes (8, 8,... 8) during the UBM discharges there is a power density of 5 to 40 W·cm⁻² and a discharge voltage of -300 to -1000 volts.

7. Process according to Claim 3, **characterized in that** the cathodes (8, 8, ... 8) are operated in the UBM mode pulsed with a frequency of 0 to 350 kHz.

8. Process according to Claim 1, **characterized in that** at the substrate(s) there is a negative potential U_{B} of 0 to -30 000 V, preferably of 0 up to -2000 V, and in particular of 0 up to -1000 V.

9. Process according to Claim 3, **characterized in that** an unbalanced magnetic field is generated at each cathode (8, 8,... 8) by means of Helmholtz coils (83), **in that** the product of the current strength I and number of turns N of the Helmholtz coils assumes a value of up to 5000 amperes (NxI = 5000 A), **in that** the unbalanced magnetic field of adjacent cathodes (8, 8) has respectively reversed polarity and **in that** the unbalanced magnetic fields of all of the cathodes (8, 8,... 8) magnetically include the discharge plasmas (8').

10. Device for the PVD coating of substrates by a process according to one of Claims 1 to 9, comprising a vacuum chamber (3), a substrate support (90), cathodes (8, 8,... 8) designed as unbalanced magnetrons, at least one electrical direct-current, pulsed-current or high-frequency alternating-voltage generator (16) and at least one electrical high-power impulse generator (15), wherein the cathodes (8, 8,... 8) are connected in parallel arrangement to an electrical direct-current, pulsed-current or high-frequency alternating-voltage generator (16) and to an electrical high-power impulse generator (15), **characterized in that** the device has a centrally arranged anode (20) and the substrates (9) are positioned between the anode (20) and the cathodes (8, 8, ... 8).

11. Device according to Claim 10, **characterized in that** each cathode (8, 8, ... 8) has a Helmholtz coil (83) and **in that** the Helmholtz coils (83) are designed for operation during which the product of the current strength I and number of turns N assumes a value of up to 5000 amperes (NxI = 5000 A).

12. Device according to Claim 10, **characterized in that** it is provided with one or more shutter devices (91) that are movable independently of one another in such a way that the cathode targets (81) of one or more cathodes (8, 8,... 8) can be separately covered.

## Revendications

1. Procédé de revêtement PVD de substrats, dans lequel un premier plasma d'une décharge électrique de courant continu, de courant pulsé ou de tension alternative haute fréquence est superposé spatialement à un second plasma d'une décharge d'impulsions de grande puissance et les plasmas s'étendent dans la direction des substrats, dans lequel le premier et le second plasma sont produits respectivement au moyen de cathodes (8, 8, ... 8) qui se présentent sous la forme de magnétrons déséquilibrés, **caractérisé en ce que** les substrats sont positionnés entre les cathodes (8, 8, ... 8) et une anode (20) agencée au centre, à laquelle un potentiel de quelques centaines de volts s'applique, et sont entourés de toutes parts par un plasma homogène.

2. Procédé selon la revendication 1, **caractérisé en ce qu'**un premier plasma d'une décharge de magnétrons déséquilibrés (UBM) est superposé spatialement à un second plasma d'une décharge d'impulsions de grande puissance.

3. Procédé selon la revendication 1, **caractérisé en ce qu'**un premier plasma d'une décharge de magnétrons déséquilibrés (UBM) est superposé spatialement à un second plasma d'une décharge de magnétrons d'impulsions de grande puissance (HIPIMS).

4. Procédé selon la revendication 3, **caractérisé en ce que** la densité de puissance électrique de cathodes des décharges HIPIMS atteint 1 000 à 10 000 W·cm⁻², de préférence 2 000 à 8 000 W·cm⁻² et en particulier 2 000 à 4 000 W·cm⁻².

5. Procédé selon la revendication 4, **caractérisé en ce que** la durée d'impulsion des décharges HIPIMS atteint 50 à 400 µs, de préférence 50 à 300 µs et en particulier 50 à 250 µs.

6. Procédé selon la revendication 3, **caractérisé en ce qu'**une densité de puissance de 5 à 40 W·cm⁻² et une tension de décharge de -300 à -1 000 volts s'appliquent aux cathodes (8, 8, ... 8) au cours des décharges UBM.

7. Procédé selon la revendication 3, **caractérisé en ce que** les cathodes (8, 8, ... 8) sont exploitées dans la commande UBM pulsées avec une fréquence de 0 à 350 kHz.

8. Procédé selon la revendication 1, **caractérisé en ce qu'**un potentiel négatif U_{B} de 0 à -30 000 V, de préférence de 0 à -2 000 V, et en particulier de 0 à -1 000 V, s'applique au(x) substrat(s).

9. Procédé selon la revendication 3, **caractérisé en ce qu'**un champ magnétique de déséquilibre est généré sur chaque cathode (8, 8, ... 8) au moyen de bobines de Helmholtz (83), **en ce que** le produit de l'intensité de courant I et du nombre de spires N des bobines de Helmholtz a une valeur allant jusqu'à 5 000 ampères (NxI = 5 000 A), le champ magnétique de déséquilibre de cathodes voisines (8, 8) présente respectivement une polarité inversée et les champs magnétiques de déséquilibre de toutes les cathodes (8, 8, ... 8) enferment magnétiquement les plasmas de décharge (8').

10. Dispositif de revêtement PVD de substrats selon un procédé selon l'une quelconque des revendications 1 à 9, comprenant une chambre à vide (3), des porte-substrats (90), des cathodes (8, 8, ... 8) qui se présentent sous la forme de magnétrons déséquilibrés, au moins un générateur électrique de courant continu, de courant pulsé ou de tension alternative haute fréquence (16) et au moins un générateur électrique d'impulsions de grande puissance (15), dans lequel les cathodes (8, 8, ... 8) sont connectées en parallèle à un générateur électrique de courant continu, de courant pulsé ou de tension alternative haute fréquence (16) et à un générateur électrique d'impulsions de grande puissance (15), **caractérisé en ce que** le dispositif présente une anode (20) agencée au centre et les substrats (9) sont positionnés entre l'anode (20) et les cathodes (8, 8, ... 8).

11. Dispositif selon la revendication 10, **caractérisé en ce que** chaque cathode (8, 8, ... 8) présente une bobine d'Helmholtz (83) et les bobines d'Helmholtz (83) sont agencées pour une exploitation dans laquelle le produit de l'intensité du courant I et du nombre de spires N a une valeur allant jusqu'à 5 000 ampères (NxI = 5 000 A).

12. Dispositif selon la revendication 10, **caractérisé en ce qu'**il est équipé d'un ou plusieurs dispositifs de diaphragme (91) déplaçables indépendamment l'un de l'autre de sorte que les cibles cathodiques (81) puissent recouvrir une ou plusieurs des cathodes (8, 8, ... 8) séparément.
